(19) Europäisches Patentamt
European Patent Office
Office européen des brevets

(11)  **EP 2 747 230 B1**

(12)  **EUROPEAN PATENT SPECIFICATION**

(45) Date of publication and mention
of the grant of the patent:
**06.04.2016  Bulletin 2016/14**

(51) Int Cl.:
***H02H 3/48*** *(2006.01)*     ***G01R 29/18*** *(2006.01)*

(21) Application number: **12460092.5**

(22) Date of filing: **21.12.2012**

(54)  **A power-based method of out of step detection in electrical power network**

Leistungsbasiertes Verfahren zur Aussertritt-Erkennung in einem Stromnetzwerk

Procédé fondée sur la puissance électrique pour détecter des déphasages dans un réseau d'alimentation électrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**25.06.2014  Bulletin 2014/26**

(73) Proprietor: **ABB Technology AG
8050 Zürich (CH)**

(72) Inventors:
• **Krata, Jaroslaw
97-200 Tomaszow Mazowiecki (PL)**
• **Balcerek, Przemyslaw
30-389 Krakow (PL)**

(74) Representative: **Chochorowska-Winiarska, Krystyna
ABB Sp. z o. o.
ul. Zeganska 1
04-713 Warszawa (PL)**

(56) References cited:
• **PAUDYAL S ET AL: "Application of Equal Area Criterion Conditions in the Time Domain for Out-of-Step Protection", IEEE TRANSACTIONS ON POWER DELIVERY, IEEE SERVICE CENTER, NEW YORK, NY, US, vol. 25, no. 2, 1 April 2010 (2010-04-01), pages 600-609, XP011300038, ISSN: 0885-8977**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to method of out of step detection in electric power network. The electrical power network may be formed from two separate power systems connected together by multiphase transmission line or from one power system and transmission line to which a generator is connected. The invention can be used also in the power system with multiple transmission lines connected to many generators, motors and loads, and in which a part of a system needs to be isolated in case of out of step occurrence. The invented method is used to protect power system against out of step condition. The method detects out of step condition using comparison of apparent power phasors from local and remote locations, where the phasor is determined.

The known methods of out of step detection in power system and/or transmission line mainly based on measurements from one end of the power system and/or transmission line. For example, an impedance method utilized local measurements of current and voltage of the system in order to calculate impedance. The impedance trajectory is monitored and basing on certain allowed area of operation the condition of the appearance of the out of step is determined.

Utilization of measurements from both ends of the power system and/or transmission line increases protection reliability and efficiency.

From patent description US 7,930,117 there is known a method for power swing and out of step detection using intelligent electronic device IED in power system. The out of step detection is based on measurement from two locations in the electrical power system. Voltage measurements may be received from the first and the second IED. The measurements may be time aligned and utilized to calculate difference of angles of voltages positive sequence between the first and the second location in the electrical power system. From the angle difference between a local and remote IED a slip frequency and acceleration may be obtained. Then the trajectory of slip frequency and acceleration may be monitored and compared to operating region and swing detecting region. The angle difference, slip frequency, and acceleration may be used to detect an out of step condition in the electrical power system and/or power swing between the first location and the second location in the electrical power system. The angle difference, slip frequency and acceleration may also be used to detect predicatively out of step conditions. However, calculating the second derivative i.e. acceleration can cause numerical errors or significant computation delay. Another disadvantage of this solution is that the method efficiency depends on the setting of operating region and swing detecting region directly.

From US patent application US2010/0302695 there is a known method of determining out of step tripping angle based on the information about voltage angle at a remote end contained in a swing current. The method comprises the following steps: measuring the current and voltage of power system, calculating the superimposed positive sequence current and superimposed positive sequence resistance, determination the change in polarity of superimposed positive sequence current $\Delta I$, determination the change in polarity of superimposed positive sequence resistance $\Delta R$, comparison change of polarity of the superimposed positive sequence current $\Delta I$ with the change in polarity of the superimposed positive sequence resistance $\Delta R$, determination recoverable swing when the change of $\Delta I$ polarity has changed with the change of $\Delta R$ polarity, determination pole slip, indicating non-recoverable swing when $\Delta I$ polarity has change whilst $\Delta R$ polarity remains unchanged, calculation the correct instant for tripping $I_{trippings}$ that corresponds to the desired angle between the two ends of the unstable power system based on pole slip detection.

The essence of the inventive method for detecting out of step in an electric power network making use of a protection device having means for measuring voltage, $V_A$, $V_B$ and current signals, $I_A$, $I_B$ of the electric lines at both local and remote terminals A and B of the electric network and having a computer means for data processing and calculation an active power P and reactive power Q at both the local terminal A and at the remote terminal B, is that the method further comprises the following steps:

- calculating an apparent power phasor $S_A$ at local terminal A and an apparent power a phasor $S_B$ at remote terminal B, based on the calculated active power P and reactive power Q,
- determining a first criterion Crit1 for out of step detection on the base of the behavior the apparent power phasor $S_A$ and the apparent power phasor $S_B$ at the same time instant $t_k$ in the following form:

$$(\text{Crit1} == 1) \Leftrightarrow (S_B \text{ crossess } S_A)$$

or

$$(\text{Crit1} == 1) \Leftrightarrow (S_A \text{ crossess } S_B)$$

where:

$S_A$ - is an apparent power phasor in local terminal,
$S_B$ - is an apparent power phasor in remote terminal,

- setting the threshold value $t_{thr}$ for the time in which the apparent power phasor $S_B$ crosses of the apparent power phasor $S_A$ or for the time in which the apparent power phasor $S_A$ crosses of the apparent power value $S_B$
- determining a second criterion Crit2 for out of step detection which has a form:

$$(\text{Crit2} == 1) \Leftrightarrow ((\text{special timer } t(d) = t_{thr}) \ AND \ (S_B \ \text{not crossess } S_A \ \text{after } t_d))$$

or

$$(\text{Crit2} == 1) \Leftrightarrow ((\text{special timer } t(d) = t_{thr}) \ AND \ (S_A \ \text{not crossess } S_B \ \text{after } t_d))$$

where:

t(d) means time duration of special timer,
$t_{thr}$ means a threshold time value for crossing time,
$t_d$ means a time instant of detection of the first criterion,

- determination out of step presence by making a logic product of the results of the criterion Crit1 and Crir2 for each sample of interest at the same time instant $t_k$,
- automatically creating a signal for activating remedial action, triggering alarm or passing the signal indicating the out of step detection to other protection devices.

Preferably the calculation of the apparent power phasor $S_A$ at the local terminal A is calculated according to the formula:

$$S_A = P_A + j \cdot Q_A$$

where:

$P_A$ - is an active power vector in local terminal,
$Q_A$ - is a reactive power in local terminal,

and an apparent power phasor $S_B$ at the local terminal B is calculated according to the formula:

$$S_B = P_B + j \cdot Q_B$$

where:

$P_B$ - is an active power in remote terminal,
$Q_B$ - is a reactive power in remote terminal.

Preferably the criteria **Crit1** and **Crit2** are checked sequentially in continuous way.

The essence of a device for implementing the method according to claims 1-3 of detecting out of step presence in an electric power network comprising means for measuring electric data in both local and remote terminal and computer means in the form of a protection relay (2) for processing measured data and adapted for calculation an active P and reactive power Q at both local and remote terminals, is that it further comprises the following means embedded in the functional modules of the protection system (7) of the protection relay (2):

- means for calculating apparent power phasors in local terminal and remote terminal, based on the calculated active power P and reactive power Q,
- means for setting and checking the criteria Crit1 and Crit2 which are embedded in an out of step detection module and in a setting module of the protection system,

- means for calculating a logic product of the criterion Crit1 and criterion Crit2 which are embedded in an out of step detection module,
- means for activation of remedial action and/or alarming the user by an electric signal when the result of the logic product is "1" which are embedded in the out of step detection module.

Preferably an input of the out of step detection module is connected with the setting module, a power calculating module and a special timer module.
Preferably the protection relay has a form of Intelligent Electronic Device IED.
Preferably the Intelligent Electronic Device IED is IED670 produced by ABB company.
Preferably the local and remote terminals are electrically connected by communications link through protective relays.
A computer program product comprising computer code which when executed in a computing device in the form of the relay caries out of the steps of a method according to the claims 1-3.

The invented method has a number of advantages over other known methods. First, due to the utilization of measurements from more than one point in the system it is able to achieve high reliability. The set of different criteria ensures that the method does not cause false alarm signals. There are no unstable mathematical operations such as derivative calculation that may cause instability of the method. Moreover, the method is easily configured as it only requires a few settings.

The method for execution the invention is presented in exemplary embodiments in the drawings where:

Fig.1 shows schematically the first electrical power network with two power systems,

Fig.2 shows the second electrical power network with one power system and one generator,

Fig.3 shows the third electrical power network with multiple transmission lines,

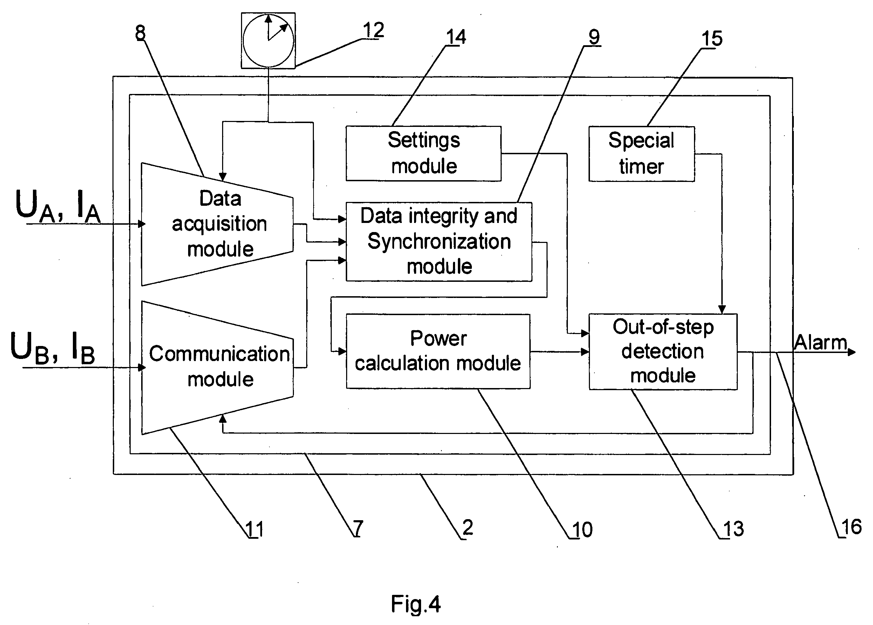

Fig.4 shows a schematic diagram of a protection relay device adapted to execute the method according to the invention,

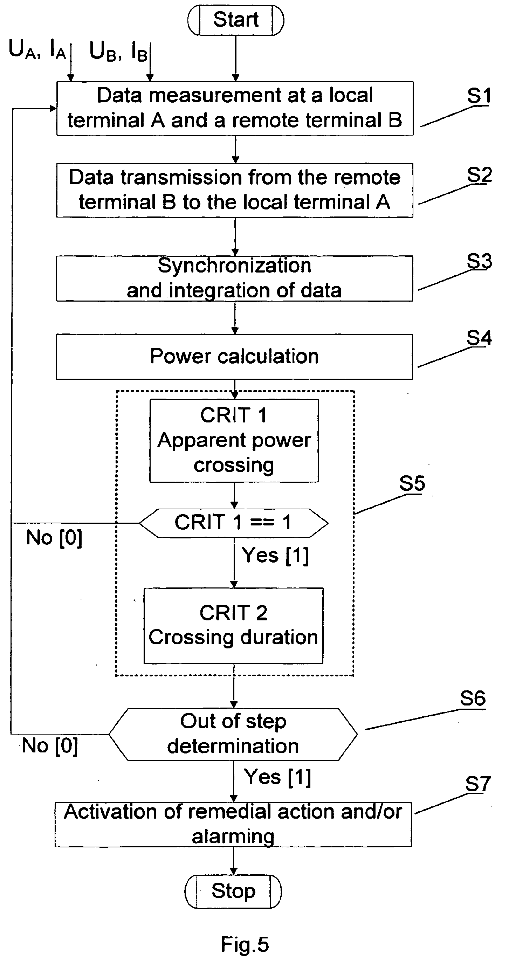

Fig.5 shows the sequence of actions performed to execute the method according to the invention,

Fig.6a presents a practical diagram for a state before detection out of step condition,

Fig.6b presents a practical diagram for the occurrence out of step condition,

Fig.6c presents the out of step condition after detection the out of step condition.

The invention is presented in exemplary embodiment s where three different electrical power networks are used.
In the first embodiment of the invention, the electrical power network has two power systems a first power system PS1 and a second power system PS2. The two power systems PS1 and PS2 are connected together with a three-phase transmission line 1. The transmission line is equipped with two measuring terminals, a first local terminal A and the second remote terminal B. Local terminal A can be also the remote terminal B where the remote terminal B plays the role of local terminal A. Each of the terminals has an electrical connection with commonly known protection relays 2. In both terminals A and B the sensors 3 for measure voltage and current from the power systems PS1 and PS2 are located. Such sensors 3 may be connected to the protection relays 2, or other microcomputer devices for gathering and processing the measured data, so not only protection relay can be used for this aims. In order to simplified the understanding of the invention only the protection relay 2 is presented as such device. Each of the relays 2 has special modules for detecting out of step condition in the power system PS1 or PS2. The details of such module are explained in other part of the description. Both protection relays 2 have communications means for providing communication link between them, which for example may be a wire link 4. Instead of wire link 4 the communication may be realized by wireless connection means.
In the second embodiment of the invention the electrical power network has the power system PS1 which is connected with the generating unit 5 through transmission line 1. In this embodiment the local terminal A is located directly in powers system PS1, what is indicated in symbolic way placing the letter A in the box PS1, and the remote terminal B is located on the line 1 between the power system PS1 and the generating unit 5. The terminals A and B are connected with the protection relays 2 playing the similar role as in the first embodiment of the invention. Both protection relays 2 have communications means for providing communication link between them, which for example may be a wire link 4. Instead of wire link 4 the communication may be realized by wireless connection means.

In the third embodiment of the invention the electrical power network has a form of many transmission lines 1 where each of the lines connects the power systems PS1 ... PS$_N$ ( where N is a natural number) with another power system, relatively, or with the generating units 5 or with loads 6. The transmission lines 1 have local terminals A and remote terminal B located on at least one the same line 1. The terminals A and B are connected with the protection relay 2 playing the similar role as in the first and second embodiment. Instead of wire link 4 the communication may be realized by wireless connection means.

In all exemplary embodiments of the invention, the first and the second protection relays 2 are used as devices for measuring, gathering and processing data. It is not important which protection relay 2 is the first or second relay because all relays used in the invented method are the identical devices. The relays 2 are electrically connected to the line 1 in the measuring terminals A or B directly with the all three phases of the line 1. In each measured terminals means for measurement current and voltage are located and these means are electrically connected with means for receiving value of the measured data, located in the protection relay 2. The means for receiving value of the measured data in terminal A and B are placed in the protection system 7 of the relay 2, in which many functional modules are implemented.

In all exemplary embodiments as a devices for measuring, gathering and processing data the relay 2 are used. It is very convenient that relay 2 has a form of a intelligent electrical devices (IED). The relays 2 are electrically connected to the line 1 in the measuring terminals A or B directly with the all three phases of the line1 and indirectly through a transformer 6. In each measured terminals means for measurement current and voltage are located and these means are electrically connected with means for receiving value of the measured data, located in the relay 2. The means for receiving value of the measured data in terminal A and B are placed in the protection system 7, implemented in the relay 2 and have a form of a data acquisition module 8. Protection system 7 contains a data integrity and synchronization module 9 which has one input connected with the module 8 and output connected with a power calculating module 10. The other outputs of module 9 are connected with a communication module 11 and clock 12. The output of the power calculating module 10 is connected with an out of step detecting module 13 which is also connected with a setting module 14 and the communication module 11. The other output of the out of step detection module 13 is also connected with a special timer module 15. All above presented modules 8 to 15 are located in the protection system 7. The out of step detecting module 13 is adapted for sending a signal 16 which can activate remedial action, alarm or pass the tripping signal further to next devices e.g. circuit breakers. The protection system 7 is connected also with the means for visualization the result of the detection what is not presented on the drawing. When the intelligent electrical devices IEDs are used as the relay 2 a relay RED 670 produced by ABB is preferred.

The invention is realized in the following steps S1-S7

**Step S1**

**Data measurement at a local terminal A and a remote terminal B**

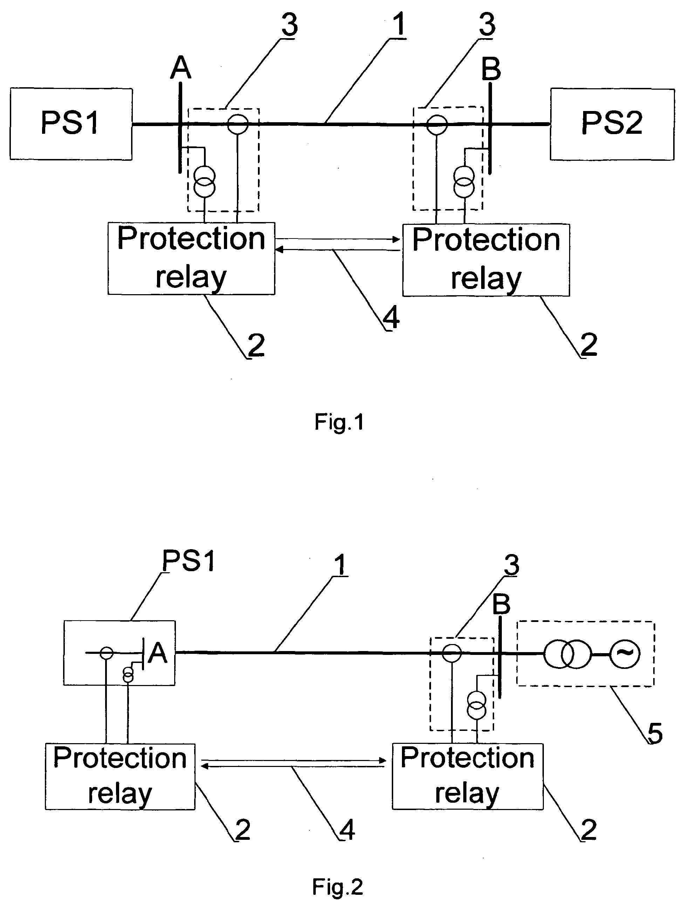

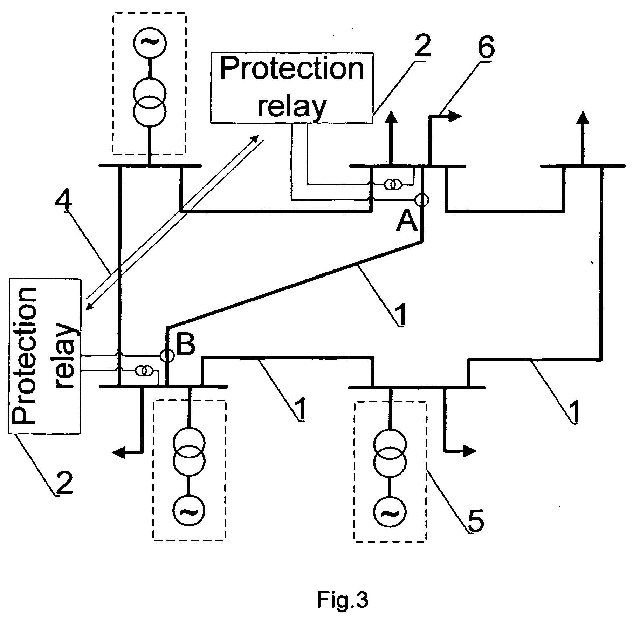

First, the three phase current $I_A$ and voltage $V_A$ signals at a local terminal A of a transmission line 1 are measured by common known sensors 3. The measured signals from terminal A are transmitted to the device for measuring and processing data, this device being a first protection relay 2 equipped with protection system 7. The measured signals are acquired by data acquisition module 8. Terminal A can be located on the transmission line between two power systems PS1 and PS2 as presented in fig.1, or between the power system PS1 and generating unit 5 as presented in fig.2, or in any place of the multiterminal power system PS1... PSn as presented in fig.3. In the protection system 7 the values of the measured the three phase voltage signal $V_A$ and the measured three phase current signal $I_A$ are gathered and recorded.

Second, the current $I_B$ and voltage $V_B$ signals at a remote terminal B of the transmission line 1 are measured by common known sensors 3. The measured signals are acquired by module 8 of the protection system 7 of the second protection relay 2 in the same way as for terminal A.

After the measurements, the signals $I_A$, $I_B$, $V_A$, $V_B$ are sampled with the frequency $f_s$ setting by user of the protection relay 2 and digitalized in a known way using a data integrity and synchronization module 9. For each k- time instant, where k indicating the consecutive number of the sample during the time t, a present time instant $t_k$ is determined. The sampling frequency $f_s$ can be fixed or variable and it is established by user - typical values of sampling frequency are between 1kHz-10kHz.

**Step S2**

**Data transmission from the remote terminal B to the local terminal A**

Next, the three phase measured and processed signals $I_B$ and $V_B$ are transmitted from terminal B to the terminal A for further processing utilizing communication link 4. The measured signals are received by a communication module 11 of protection system 7 of the first protection relay 2. In the protection system 7 of the first protection relay 2 the values of the received signals at the terminal B are gathered and recorded.

**Step S3**

**Synchronization and integration of data**

At the step S3 which is executed in data integrity and synchronization module 8 the processed data from local terminal A and the remote terminal B is time-synchronized in order to run further processes on the data with the same time instance $t_k$ The data is synchronized according to the clock 12.

**Step S4**

**Power calculation**

First, at step S4 an active power $P_A$ and reactive power $Q_A$, in terminal A and active power $P_B$ and reactive power $Q_B$ in terminal B are calculated in one of the well-known way using the data obtained in step 3. The calculation takes place in power calculation module 10 of the protection system 7.

Second, apparent power phasor $S_A$ in terminal A and an apparent power phasor $S_B$ in terminal B are calculated basing on active power $P_A$, $P_B$, and reactive power $Q_A$, $Q_B$. As the result of calculation, the following values are obtained:

$$S_A = P_A + j \cdot Q_A \qquad\qquad (1)$$

$$S_B = P_B + j \cdot Q_B \qquad\qquad (2)$$

where:

$S_A$ - is the apparent power phasor in local terminal,
$S_B$ -is the apparent power phasor in remote terminal,
$P_A$ - is the active power in local terminal,
$P_B$ - is the active power in remote terminal,
$Q_A$ - is the reactive power in local terminal,
$Q_B$ - is the reactive power in remote terminal.

**Step S5**

**Determination of Out of step conditions**

At step S5 the criteria **Crit1** and **Crit2** of out of step condition are determined and examined in order to prepare the signals of logic value "1" or "0" for next actions. The step S5 is executed in the out of step detection module 13 of the protection system 7.

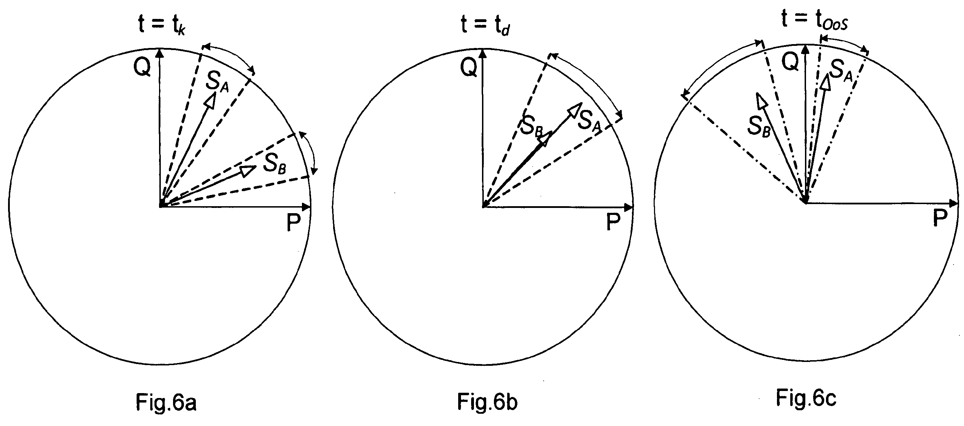

The first criterion **Crit1** relies on the identification of a time instant $t_d$ of crossing the phasor of the apparent power $S_A$ and the phasor of the apparent power $S_B$ by themselves. Fig.6a presents the phasors $S_A$ and $S_B$ in Cartesian coordinate system where on one axis the active power P is presented and on the other the reactive power Q is presented. The dotted lines present a range of the swings of apparent power phasors $S_A$ and $S_B$ in normal work condition before the out of step presence is detected where the time instant t is indicated as time instant $t_k$. The phasor $S_B$ is lying on the right side of the phasor $S_A$.

In fig.6b is presented the moment of occurrence of out of step condition. The phasor of the apparent power $S_B$ crosses the phasor of the apparent power $S_A$ in the time instant $t_d$. For the time instant $t_d$ when one of the phasors crosses the other, a first criterion is formulated as the following:

$$(Crit1 == 1) \Leftrightarrow (S_B\ crossess\ S_A) \qquad\qquad (3)$$

or

$$(Crit1 == 1) \Leftrightarrow (S_A \; crossess \; S_B) \qquad\qquad (4)$$

where:

$S_A$ - is the apparent power phasor in local terminal,
$S_B$ - is the apparent power phasor in remote terminal.
Crit1 == 1 - the logic value of an equation (3) or (4) what means true.

When the criterion **Crit1** is met, the result of this step is 1. In the opposite case the result is 0.

After the detection the time instant $t_d$ both phasors $S_A$ and $S_B$ can continue the swings in their swing's ranges or one of it can stay still. In the exemplary position presented on fig.6c the phasor $S_B$ changed its lying from the rights side to the left side of the phasor $S_A$.

After **Crit1** is fulfilled when the time instant $t_d$ is determined, in order to ensure reliable out of step detection, the second criterion **Crit2** is applied. The second criterion relies on the determination of whether for certain time $t_{thr}$ apparent power phasor $S_B$ did not cross back through the phasor $S_A$ or vice versa. For that purpose special timer $t_d$ with a treshold time $t_{thr}$ is started to run during the process. The special timer $t_d$ starts from the next time instant after $t_d$ and lasts until the threshold time $t_{thr}$ is achieved. The threshold time $t_{thr}$ is established by the user that prevents against the situation where one of the phasors $S_A$ or $S_B$ crosses the other the next times. The threshold time $t_{thr}$ is given by the user in the setting module 14 of protection system 7 and is typically 20ms. Out of step existence is considered if following formula is fulfilled:

$$(Crit2 == 1) \Leftrightarrow ((special \; timer \; t(d) = t_{thr}) \; AND \; (S_B \; not \; crossess \; S_A \; after \; t_d)) \quad (5)$$

or

$$(Crit2 == 1) \Leftrightarrow ((special \; timer \; t(d) = t_{thr}) \; AND \; (S_A \; not \; crossess \; S_B \; after \; t_d)) \quad (6)$$

where:

t(d) - time duration of special timer,
$t_{thr}$ - is a threshold time value for crossing time,
$t_d$ - is a time instant of detection the first criterion,
Crit2 == 1 means the logic value of an equation (5) or (6) what means true. When the criterion **Crit2** is met the result of this step is 1. In the opposite case, the result is 0.

The criteria **Crit1** and **Crit2** are checked sequentionally in continuous way. When all the criteria are fulfilled, the step S5 gives signal of logic 1 - true. In opposite situation step S5 gives the signal of logic 0 - false.

**Step S6**

**Out of step determination**

At the step S6 the condition for appearance of out of step is checked in such a way that when result of step S5 is "1" then the out of step is determined for the time $t_d$ and then the next step S7 is performed. In the opposite situation, the method returns back to step S1 and processes the method in iterative way. Step S6 is executed in module 13 of protection system 7. When out of step condition occurs, the phasor of apparent power $S_A$ and the phasor of apparent power $S_B$ can swing in continuous way or stay in place presented on fig.6c. In such situation a time instant $t_{Oos}$ indicates the condition after out of step occurrence.

**Step S7**

**Activation of remedial action and/or alarming**

At this step the detection signal is automatically released in order to activate remedial action, alarm or pass the tripping signal further to next devices e.g. circuit breakers. The step S7 is presented as the output signal 16 of protection system 7 which can be set on the output of the protection system 7 in protection relay 2 or send to communication module 11 for further processes.

**Claims**

1.   A method of detecting out of step in an electric power network making use of a protection device having means for measuring vottage, ($V_A$, $V_B$) and current signals, ($I_A$, $I_B$) of the electric lines (1) at both local (A) and remote (B) terminals of the electric network and having a computer means for data processing and calculation of an active power (P) and reactive power (Q) at both the local terminal (A) and at the remote terminal (B), the method further comprises the following steps:

   - calculating an apparent power phasor $S_A$ at the local terminal (A) and an apparent power phasor $S_B$ at the remote terminal (B), based on the calculated active power (P) and reactive power (Q),
   - determining a first criterion Crit1 for out of step detection on the base of the behavior of the apparent power phasor $S_A$ and the apparent power phasor $S_B$ at the same time instant $t_k$ in the following form:

$$(\text{Crit1} == 1) \Leftrightarrow (S_B \; crossess \; S_A)$$

   where:

   $S_A$ - is an apparent power phasor in local terminal,
   $S_B$ - is an apparent power phasor in remote terminal,

   - setting the threshold value $t_{thr}$ for the time in which the apparent power phasor $S_B$ crosses of the apparent power phasor $S_A$ or for the time in which the apparent power phasor $S_A$ crosses of the apparent power value $S_B$,
   - determining a second criterion Crit2 for out of step detection which has a form:

$$(\text{Crit2} == 1) \Leftrightarrow ((special \; timer \; t(d) = t_{thr}) \; AND \; (S_B \; not \; crossess \; S_A \; after \; t_d))$$

   or

$$(\text{Crit2} == 1) \Leftrightarrow ((special \; timer \; t(d) = t_{thr}) \; AND \; (S_A \; not \; crossess \; S_B \; after \; t_d))$$

   where:

   t(d) means time duration of special timer,
   $t_{thr}$ means a threshold time value for crossing time,
   $t_d$ means a time instant of detection of the first criterion,

   - determining out of step presence by making a logic product of the results of the criterion Crit1 and Crir2 for each sample of interest at the same time instant,
   - automatically creating a signal for activating remedial action, triggering alarm or passing the signal indicating the out of step detection to other protection devices.

2.   The method according to claim 1, **characterized in that** the calculation of the apparent power phasor $S_A$ at the local terminal (A) is calculated according to the formula:

$$S_A = P_A + j \cdot Q_A$$

where:

$P_A$ - is an active power vector in the local terminal (A),
$Q_A$ - is a reactive power in the local terminal (A),

and an apparent power phasor $S_B$ at the remote terminal (B) is calculated according to the formula:

$$S_B = P_B + j \cdot Q_B$$

where:

$P_B$ - is an active power in the remote terminal (B),
$Q_B$ - is a reactive power in the remote terminal (B).

3. The method according to claim 1-2, **characterized in that** the criteria Crit1 and Crit2 are checked sequentially in continuous way.

4. A device for implementing the method according to claims 1-3 of detecting out of step presence in an electric power network comprising means for measuring electric data in both local (A) and remote (B) terminals and computer means in the form of a protection relay (2) for processing measured data and adapted for calculation of an active (P) and reactive power (Q) at both local (1) and remote (B) terminals, **characterized in that** it further contains the following means embedded in the functional modules of the protection system (7) of the protection relay (2):

   - means for calculating apparent power phasors in the local terminal (A) and the remote terminal (B), based on the calculated active power (P) and reactive power (Q),
   - means for setting and checking the criteria Crit1 and Crit2 which are embedded in an out of step detection module (13), a setting module (14) and a special timer module (15) of the protection system (7),
   - means for calculating a logic product of the criterion Crit1 and criterion Crit2 which are embedded in an out of step detection module (13),
   - means for activation of remedial action and/or alarming the user by a signal (16) when the result of the logic product is "1" which are embedded in the out of step detection module (13).

5. A device according to claim 4, **characterized in that** the input of the out of step detection module (13) is connected with the setting module (14), a power calculating module (10) and a special timer module (15).

6. A device according to claim 4, **characterized in that** the protection relay (2) has a form of Intelligent Electronic Device IED.

7. A device according to claim 4- 6, **characterized in that** the local and remote terminals are electrically connected by communications link (4) through protective relays (2).

8. A computer program product comprising computer code which when executed in a computing device (2) caries out of the steps of a method according to the claims 1-3.


**Patentansprüche**

1. Ein leistungsbasiertes Verfahren zur Außertritt-Erkennung in einem Stromnetzwerk, das eine Schutzeinrichtung benutzt, die Mittel zur Messung der Spannungssignale ($V_A$, $V_B$) und der Stromsignale ($I_A$, $I_B$) der elektrischen Leitungen (1), sowohl an örtlichen (A) als auch an weit entfernten Stationen (B) des Stromnetzwerks, besitzt und die Computereinrichtungen zur Verarbeitung und Berechnung einer Wirkleistung (P) und einer Blindleistung (Q) sowohl an den örtlichen (A) als auch an den entfernten Stationen (B) des Stromnetzwerks besitzt, wobei das Verfahren darüber hinaus die folgenden Schritte beinhaltet:

- Berechnung eines Phasors der Scheinleistung $S_A$ an der örtlichen Station (A) und eines Phasors der Scheinleistung $S_B$ an der entfernten Station (B), basierend auf der berechneten Wirkleistung (P) und Blindleistung (Q),
- Bestimmung eines ersten Kriteriums Crit1 zur Außertritt-Erkennung in einem Stromnetzwerk auf der Grundlage des Verhaltens des Phasors der Scheinleistung $S_A$ und des Phasors der Scheinleistung $S_B$ zum gleichen Zeitpunkt $t_k$ gemäß der folgenden Formel:

$$(\text{Crit1} == 1) \Leftrightarrow (S_B \; crossess \; S_A)$$

wobei gilt:

$S_A$ - ist ein Phasor der Scheinleistung $S_A$ an der örtlichen Station (A),
$S_B$ - ist ein Phasor der Scheinleistung $S_B$ an der entfernten Station (B),

- Festsetzung des Schwellenwertes $t_{thr}$ für die Zeit, in der sich der Phasor der Scheinleistung $S_B$ mit dem Phasor der Scheinleistung $S_A$ überkreuzt, oder für die Zeit, in der sich der Phasor der Scheinleistung $S_A$ mit dem Phasor der Scheinleistung $S_B$ überkreuzt,
- Bestimmung eines zweiten Kriteriums Crit2 zur Außertritt-Erkennung in einm Stromnetzwerk gemäß der folgenden Formel:

$$(\text{Crit2} == 1) \Leftrightarrow ((special \; timer \; t(d) = t_{thr}) \; AND \; (S_B \; not \; crosses \; S_A \; after \; t_d))$$

oder

$$(\text{Crit2} == 1) \Leftrightarrow ((special \; timer \; t(d) = t_{thr}) \; AND \; (S_A \; not \; crosses \; S_B \; after \; t_d))$$

wobei gilt:

$t(d)$ - Zeitdauer des speziellen Zeitgebers,
$t_{thr}$ - Schwellenwert für die Überkreuzungszeit,
$t_d$ - Zeitpunkt der Feststellung des ersten Kriteriums,

- Erkennung eines Außertritt-Zustandes in einem Stromnetzwerk durch Bildung eines logischen Produktes aus den Ergebnissen der Kriterien Crit1 und Crit2 für jede analysierte Stichprobe zum selben Zeitpunkt,
- Automatische Erzeugung eines Signals zur Aktivierung einer Abhilfemaßnahme, Auslösung eines Alarms oder Übermittlung eines Signals über die Detektion des Außertritt-Zustandes in einem Stromnetzwerk an andere Schutzeinrichtungen.

2. Das Verfahren gemäß Anspruch 1, **dadurch gekennzeichnet, dass** die Berechnung des Phasors der Scheinleistung $S_A$ an der örtlichen Station (A) gemäß der folgenden Formel erfolgt:

$$S_A = P_A + j \cdot Q_A$$

wobei gilt:

$P_A$ - ist ein Vektor der Wirkleistung an der örtlichen Station (A),
$Q_A$ - ist ein Vektor der Blindleistung an der örtlichen Station (A),

und die Berechnung des Phasors der Scheinleistung $S_B$ an der entfernten Station (B) gemäß der folgenden Formel erfolgt:

$$S_B = P_B + j \cdot Q_B$$

wobei gilt:

> $P_B$ - ist ein Vektor der Wirkleistung an der örtlichen Station (B),
> $Q_B$ - ist ein Vektor der Blindleistung an der örtlichen Station (B),

3. Das Verfahren gemäß den Ansprüchen 1-2, **dadurch gekennzeichnet, dass** die Kriterien **Crit1** und **Crit2** aufeinanderfolgend und kontinuierlich überprüft werden.

4. Eine Einrichtung zur Ausführung des Verfahrens gemäß den Ansprüchen 1-3 zur Außertritt-Erkennung in einem Stromnetzwerk, die Mittel zur Messung elektrischer Daten, sowohl in örtlichen (A) als auch in entfernten (B) Stationen, besitzt sowie Computereinrichtungen in der Form eines Schutzrelais (2) zur Verarbeitung der Messdaten umfasst und zur Berechnung der Wirkleistung (P) und der Blindleistung (Q) sowohl in örtlichen (A) als auch in entfernten (B) Stationen geeignet ist, **dadurch gekennzeichnet, dass** sie darüber hinaus die folgenden Mittel enthält, die in die funktionalen Module des Schutzsystems (7) des Schutzrelais (2) eingebettet sind:

> - Mittel zur Berechnung von Phasoren der Scheinleistung an der örtlichen Station (A) und an der entfernten Station (B), basierend auf der berechneten Wirkleistung (P) und Blindleistung (Q),
> - Mittel zur Einstellung und Überprüfung der Kriterien Crit1 und Crit2, die in ein Modul zur Außertritt-Erkennung in einem Stromnetzwerk (13), ein Einstellungsmodul (14) und ein spezielles Zeitgebermodul (15) des Schutzsystems (7) eingebettet sind,
> - Mittel zur Berechnung eines logischen Produktes der Kriterien Crit1 und Crit2, die in das Modul zur Außertritt-Erkennung (13) eigebettet sind ,
> - Mittel zur Aktivierung einer Abhilfemaßnahme und/oder zur Alarmierung des Benutzers durch ein Alarmsignal (16), wenn das Produkt des logischen Produktes "1" ist, die in das Modul zur Außertritt-Erkennung (13) eigebettet sind.

5. Eine Einrichtung gemäß Anspruch 4, **dadurch gekennzeichnet, dass** die Dateneingabe des Moduls zur Außertritt-Erkennung (13) in einem Stromnetzwerk mit dem Einstellungsmodul (14), einem Leistungsberechnungsmodul (10) und einem speziellen Zeitgebermodul (15) verbunden ist.

6. Eine Einrichtung gemäß Anspruch 4, **dadurch gekennzeichnet, dass** das Schutzrelais (2) die Form einer intelligenten elektronischen Einrichtung IED hat.

7. Eine Einrichtung gemäß den Ansprüchen 4-6, **dadurch gekennzeichnet, dass** die örtlichen und die entfernten Stationen durch Kommunikationsverbindungen (4) elektrisch mit Hilfe der Schutzrelais (2) verbunden sind.

8. Ein Computerprogramm-Produkt, das den Computercode enthält, der nach der Inbetriebnahme in einer Computereinrichtung (2) das Verfahren zur Außertritt-Erkennung in einem Stromnetzwerk nach den Schritten gemäß den Ansprüchen 1-3 durchführt.

**Revendications**

1. Procédé fondé sur la puissance électrique pour détecter des déphasages dans un réseau d'alimentation électrique, faisant l'usage d'un dispositif de protection ayant des moyens pour mesurer des signaux de tension ($V_A$, $V_B$) et des signaux de courant ($I_A$, $I_B$) des lignes électriques (1 autant à la borne locale (A) qu'à la borne distante (B) du réseau d'alimentation électrique et ayant des moyens informatiques pour le traitement de données et le calcul de la puissance active (P) et de la puissance réactive (Q) autant à la borne locale (A) qu'à la borne distante (B), le procédé comprenant les étapes suivantes :

> - calcul du phaseur de la puissance apparente $SA$ à la borne locale (A) et du phaseur de la puissance apparente $S_B$ à la borne distante (B), fondé sur la puissance active calculée (P) et la puissance réactive (Q),
> - détermination du premier critère Crit1 pour la détection du déphasage à base du comportement du phaseur de la puissance apparente $S_A$ et du phaseur de la puissance apparente $S_B$ au même instant du temps $t_k$ sous la forme suivante :

$$(\text{Crit1} == 1) \Leftrightarrow (S_B \; crossess \; S_A)$$

où :

$S_A$ - est un phaseur de la puissance apparente à la borne locale
$S_B$ - est un phaseur de la puissance apparente à la borne distante

- détermination de la valeur de seuil $t_{thr}$ pour le temps où le phaseur de la puissance apparente $S_B$ croise le phaseur de la puissance apparente $S_A$ ou pour le temps où le phaseur de la puissance apparente $S_A$ croise le phaseur de la puissance apparente $S_B$,
- détermination du second critère Crit2 pour la détection du déphasage qui a la forme :

$$(\text{Crit2} == 1) \Leftrightarrow ((special \; timer \; t(d) = t_{thr}) \; AND \; (S_B \; not \; crosses \; S_A \; after \; t_d))$$

ou

$$(\text{Crit2} == 1) \Leftrightarrow ((special \; timer \; t(d) = t_{thr}) \; AND \; (S_A \; not \; crossess \; S_B \; after \; t_d))$$

où :

$t(d)$ signifie le temps de durée du régulateur temporel spécial,
$t_{thr}$ signifie la valeur de seuil du croisement des phaseurs,
$t_d$ signifie la constante temporelle de détection du premier critère,

- détermination de la présence du déphasage par le produit logique des critères Crit1 et Crit2 pour chaque échantillon analysé au même moment,
- création automatique d'un signal permettant d'activer une action correctrice, le déclenchement d'une alarme ou la transmission du signal indiquant la détection du déphasage à d'autres dispositifs de protection.

2. Procédé selon la revendication 1, caractérisé de ce que le calcul du phaseur de la puissance apparente $S_A$ à la borne locale (A) est exécuté selon la formule suivante :

$$S_A = P_A + j \cdot Q_A$$

où :

$P_A$ - est un vecteur de la puissance active à la borne locale (A),
$Q_A$ - est un vecteur de la puissance réactive à la borne locale (A),

et le phaseur de la puissance apparente $S_B$ à la borne distante (B) est calculé selon la formule suivante :

$$S_B = P_B + j \cdot Q_B$$

où

$P_B$ - est un vecteur de la puissance active à la borne distante (B),
$Q_B$ - est un vecteur de la puissance réactive à la borne distante (B).

3. Procédé selon les revendications 1-2, caractérisé de ce que les critères Crit1 i Crit2 sont vérifiés successivement de manière permanente.

**4.** Dispositif pour la mise en oeuvre du procédé selon les revendications 1-3 de détection de déphasage dans un réseau d'alimentation électrique, comprenant les moyens pour mesurer les données électriques autant à la borne locale (A) qu'à la borne distante (B) et les moyens informatiques pour le traitement de données sous forme d'un relais de protection (2) adapté à calculer la puissance active (P) et la puissance réactive (Q) autant à la borne locale (A) qu'à la borne distante (B), **caractérisé en ce qu'**il contient en outre les moyens suivants compris dans le module fonctionnel du système de protection (7) du relais de protection (2) :

- moyens pour calculer le phaseur de la puissance apparente à la borne locale (A) et à la borne distante (B), basés sur la puissance active calculée (P) et sur la puissance réactive (Q),
- moyens pour déterminer et vérifier les critères Crit1, Crit2 qui sont compris dans le module de détection de déphasage (13), le module de régulation de consignes (14) et le module spécial de régulateur temporel (15) du système de protection (7),
- moyens pour calculer le produit logique des critères Crit1 i Crit2 qui sont compris dans le module de détection de déphasage (13),
- moyens pour activer les actions correctrices et / ou déclencher une alarme pour alerter l'utilisateur à l'aide d'un signal sonore (16) lorsque le résultat du produit logique est "1", lesquels sont implantés dans le module de détection de déphasage (13).

**5.** Dispositif selon la revendication 4, **caractérisé en ce que** l'entrée du module de détection de déphasage (13) est connectée au module de régulation de consignes (14), au module de calcul de la puissance (10) et au module spécial de régulateur temporel (15).

**6.** Dispositif selon la revendication 4, **caractérisé en ce que** le relais de protection (2) a la forme de Dispositif Electronique Intelligent DEI.

**7.** Dispositif selon les revendications 4-6, **caractérisé en ce que** les bornes locale et distante sont connectées électriquement par l'intermédiaire d'une liaison de communication (4) du relais de protection (2).

**8.** Produit d'un logiciel informatique comprenant un code d'ordinateur lequel, mis en marche sur le dispositif de calcul (2), exécute le procédé de détection de déphasage dans les réseaux électriques conformément aux pas selon les revendications 1-3.

Fig.1

Fig.2

Fig.3

Fig.4

Fig.5

t = $t_k$

Fig.6a

t = $t_d$

Fig.6b

t = $t_{OoS}$

Fig.6c

EP 2 747 230 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7930117 B

- US 20100302695 A